# EUROPEAN PATENT APPLICATION

(11) **EP 2 317 342 A2**
(43) Date of publication of application: **04.05.2011**
(21) Application number: 10189734.6
(22) Date of filing: 02.11.2010
(51) Int. Cl.: G01V 3/10

(54) **Enhanced Performance Proximity Sensor**

(30) Priority: 02.11.2009 US 610603
(71) Applicant: Rockwell Automation Technologies, Inc., Mayfield Heights, OH 44124 (US)
(72) Inventor: Kayserman, Isak, Needham, MA 02494 (US); Santos, Roberto S., Hudson, MA 01749 (US); Sun, James F., Andover, MA 01810 (US); Sufariu, Diana A., Nashua, NH 03062 (US)
(74) Representative: Grünecker, Kinkeldey, Stockmair & Schwanhäusser Anwaltssozietät

(57) **Abstract**

An industrial control sensor is provided. The sensor includes a sensor circuit to detect changes in an electromagnetic field induced from an object or material passing in proximity of the electromagnetic field. This includes a housing that employs the sensor circuit as part of an inductive proximity sensor. A sensor face is attached to the housing, where the sensor face receives the changes in the electromagnetic field and transmits the changes to the sensor circuit, and where the sensor face has a higher electrical resistivity or a lower temperature coefficient of resistivity than stainless steel.

## Description

### TECHNICAL FIELD

The claimed subject matter relates generally to industrial control systems and more particularly to inductive proximity sensors that employ materials with a high electrical resistivity and/or low temperature coefficient of resistivity to improve sensor performance.

### BACKGROUND

Inductive proximity sensors are employed in a variety of applications, and more particularly, in automated assembly lines, in machinery, packaging, and automotive markets, for example. Generally, inductive sensors utilize an electromagnetic field to detect the presence/absence of an object, the distance to an object, or the nature of an object (ferrous or non-ferrous metal). These measurements are based on the detection of changes in the electromagnetic field which is generated by an oscillator.

In general, an inductive proximity sensor consists of a coil assembly, an oscillator, a trigger-signal level detector and an output circuit. When a ferrous or nonferrous metallic object moves into the electromagnetic field situated in front of the proximity sensor face, eddy currents are induced in the metallic object which produces a load on the oscillator. This additional load results in a loss of energy and a change in amplitude of oscillation and hence leads to object detection, which is often conveyed by a transistor or relay output switch indication.

One parameter of interest when considering such devices is the detection range, otherwise known as the nominal sensing distance. The nominal sensing distance is defined by a theoretical value corresponding to the detection of a standard one millimeter thick mild steel square target with axial approach. The target could be an object that is manufactured (object sensing) or a part of a machine (machine sensing). The latter is predominantly the case for inductive sensors.

Due to the harsh environments these sensors are utilized in, there is a market need for rugged packaging. One of the techniques used to provide such capability is the use of a metal housing and sensor face. Metal face inductive proximity sensors provide superior impact, abrasion, and chemical resistance compared to their plastic face counterparts. Austenitic stainless steel, in different grades, has been the preferred metal for the fabrication of the housing and sensor face because it is inexpensive and generally exhibits excellent corrosion resistance over time.

When an electromagnetic field interacts with the face of the sensor, eddy currents are formed on both the sensor face and target. If the face material has low electrical resistivity, such as copper or aluminum, for example, the intensity of these currents on the face are too great, and thus do not allow the electromagnetic field to adequately penetrate the material. A material with a high electrical resistivity is thus preferred in order to reduce the intensity of these eddy currents on the sensing face and allow for adequate penetration of the electromagnetic field through the sensing face. Austenitic stainless steel, in different grades, has the added benefit of allowing the electromagnetic field to adequately penetrate it.

Although a mechanically and economically suitable choice for the sensor face material, stainless steel does have some drawbacks. One problem is that stainless steel has undesirable temperature performance due to its physical properties. The electrical resistivity of a material varies as a function of temperature. The electrical resistivity of a material generally increases with increasing temperature and decreases with decreasing temperature. As a result, the magnitude of the induced eddy currents in the sensor face also varies with temperature changes.

Ideally, when the environmental temperature changes, the functionalities of the sensor, such as sensing distance, should not be affected. Therefore, temperature compensation circuits are often employed in inductive proximity sensors. However, in some situations, the temperature changes so quickly that the sensor housing/face combination endures these changes first. The temperature compensation circuits, most often buried in the middle of the sensor body, can not react promptly enough to the temperature change, thereby causing inaccurate sensing or false detection.

Existing stainless steel inductive proximity products are typically fabricated either by machining the housing and face as a singular stainless steel part or by fabricating the housing and sensor face as two distinct stainless steel parts and then laser welding them together. These conventional sensor construction techniques have led designers to look away from other sensor face materials. For instance, since stainless steel is an economically suitable choice for the actual housing of the sensor, it also makes sense to employ stainless steel as the face material, particularly due to the known complexities of joining dissimilar materials. Thus, for these reasons and others, designers have had little reason to look for solutions other than stainless steel for the sensor face material.

### SUMMARY

The following summary presents a simplified overview to provide a basic understanding of certain aspects described herein. This summary is not an extensive overview nor is it intended to identify critical elements or delineate the scope of the aspects described herein. The sole purpose of this summary is to present some features in a simplified form as a prelude to a more detailed description presented later.

An enhanced inductive proximity sensor having improved sensing distances or less sensitivity to temperature changes is provided. In one aspect, a material having a higher electrical resistivity and/or lower temperature coefficient of resistivity than stainless steel is selected for use as the sensor face in order to facilitate such properties.

When an electromagnetic field interacts with the face of the sensor, eddy currents are formed on the sensor face and target. A material with a high electrical resistivity, such as a titanium alloy, for example, can be employed to reduce the intensity of the eddy currents on the sensing face and allow for improved penetration of the electromagnetic field through the sensing face. In general, the electrical resistivity of these metallic materials also changes with temperature. Titanium alloys have a low temperature coefficient of resistivity. The high electrical resistivity and low temperature coefficient of resistivity associated with titanium alloys, for example, provides a significant advance for inductive proximity sensor applications. Thus, a sensor face constructed from such a material can increase the achievable sensing distance and also reduce the sensor's sensitivity to sudden temperature changes in the environment.

Advanced joining techniques can be employed to couple the face material to a housing material that may be dissimilar from that of the sensor face. In one particular aspect, titanium (or alloys thereof) can be employed as the face material and possibly the housing material. The shape and thickness of the sensor face and associated housing can vary depending upon application needs.

The use of titanium as the material for the entire housing, while being suitable from a functional perspective, may be less than suitable from a cost perspective. However, with advanced joining techniques for dissimilar metals, the use of titanium alloys as the sensor face coupled with stainless steel, nickel plated brass, anodized aluminum, a different titanium material, or other materials for the housing provides a cost-effective yet robust solution well suited for a wider range of operating conditions.

To the accomplishment of the foregoing and related ends, the following description and annexed drawings set forth in detail certain illustrative aspects. These aspects are indicative of but a few of the various ways in which the principles described herein may be employed. Other advantages and novel features may become apparent from the following detailed description when considered in conjunction with the drawings.

### BRIEF DESCRIPTION OF THE DRAWINGS

Fig. 1 is a schematic block diagram illustrating an inductive proximity sensor that is part of an industrial control process.

Fig. 2 is a diagram illustrating a detailed inductive proximity sensor.

Fig. 3 is a perspective view of an industrial control, such as an inductive proximity sensor.

Fig. 4 is a cross-sectional view of an inductive proximity sensor.

Fig. 5 is a diagram illustrating typical performance curves.

Fig. 6 is a diagram illustrating the performance of example sensor face material combinations.

Figs. 7-13 illustrate example sensor housing constructions.

Fig. 14 is a diagram illustrating example titanium compositions that can be employed with an enhanced proximity sensor.

Fig. 15 is a flow diagram illustrating an example process for an enhanced inductive proximity sensor.

### DETAILED DESCRIPTION

An enhanced inductive proximity sensor having improved sensing distances and less sensitivity to temperature changes is provided. In one aspect, an industrial control sensor is provided. The sensor includes a sensor circuit to detect changes in an electromagnetic field induced from an object or material passing in proximity of the electromagnetic field. This includes a housing that employs the sensor circuit as part of an inductive proximity sensor. A sensor face is attached to the housing, where the sensor face receives the changes in the magnetic field and transmits the changes to the sensor circuit, and where the sensor face has a higher electrical resistivity and/or a lower temperature coefficient of resistivity than stainless steel.

It is noted that the use of materials with a high electrical resistivity is desirable to reduce the magnitude of eddy currents generated in the sensing face and to reduce the influence on the oscillation. As a result, the sensor is less vulnerable to temperature changes. A material with a low temperature coefficient of resistivity will also provide a similar benefit. Yet another benefit of using a material with high electrical resistivity and/or low temperature coefficient of resistivity for the sensor face is that the sensing distance could be increased. Longer sensing distances are always pursued for inductive proximity sensors used in industrial applications. As a result, sensor circuitry is designed to detect even smaller changes to the electromagnetic field than ever before. More often, these changes in the eddy currents, as a result of temperature changes, are large enough to disturb the normal sensing operation of the inductive proximity sensor. In another aspect, using materials with a high electrical resistivity as the sensor face will result in a lower magnitude of eddy currents being generated in the sensor face and lower energy loss in the sensor circuitry. Therefore, a greater sensitivity or longer sensing distance can be achieved.

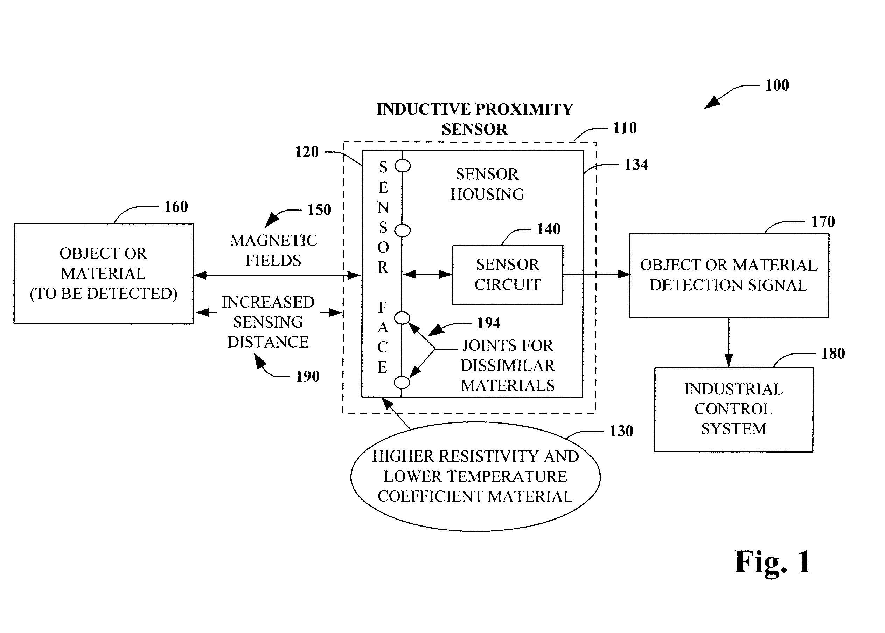

Referring initially to **Fig. 1****,** a system 100 illustrates an industrial control process 100 that employs an inductive proximity sensor 110. The inductive proximity sensor 110 (also referred to as the sensor) includes a sensor face 120 that employs a material with a high electrical resistivity and/or low temperature coefficient of resistivity and shown as properties 130 to provide enhanced sensor performance. The sensor 110 includes a housing 134 having a sensor circuit 140 that generates an electromagnetic field 150 through the sensor face 120. As an object 160 (or material) enters within proximity of the electromagnetic field 150, a disturbance is detected by the sensor circuit 140 which generates an object or material detection signal 170 which can then be processed by an industrial control system 180. The detection signal 170 is typically an output from a relay, thyristor, or transistor, for example.

By employing high electrical resistivity/low temperature coefficient of resistivity materials for the sensor face 120, increased sensing distances can be achieved as shown at 190. Such properties 130 also facilitate better performance as temperature changes such as less false-detection when temperatures change. It is noted that the sensor face 120 and the housing 134 are typically constructed from dissimilar materials. Thus, specialized joining techniques (described in more detail below) are provided to generate joints 194 between the sensor face 120 face and housing 134.

In general, an enhanced inductive proximity sensor 110 having improved sensing distances 190 and less sensitivity to temperature changes is provided. In one aspect, a material with a high electrical resistivity and/or low temperature coefficient of resistivity qualities than stainless steal is selected as the sensor face material at 120 to facilitate such properties. Advanced joining techniques at 194 are then employed to couple the face material 120 to a housing material 134 that may be dissimilar from that of the sensor face. In one particular aspect, titanium (or alloys thereof) can be employed as the face material and possibly the housing material. The shape and thickness of the sensor face 120 and associated housing 134 can vary depending on application needs. When an electromagnetic field 150 interacts with the face of the sensor 110, eddy currents are formed on the sensor face 120 and associated target. If the face material has a low electrical resistivity, such as copper or aluminum, for example, the intensity of these currents on the face is too great, and thus do not allow the electromagnetic field 150 to adequately penetrate the material. A high electrical resistivity material is thus preferred. The electrical resistivity also changes with temperature. Another reason for employing titanium is its low temperature coefficient of resistivity. The high electrical resistivity and low temperature coefficient of resistivity provide a significant advance for inductive proximity sensor applications. Thus, such sensor face material 120 can increase the achievable sensing distance 190 and also cause the sensor 110 to be less sensitive to sudden changes in temperature in the environment. The use of titanium as the material for the entire housing 134 may be less than suitable from a cost prospective. However with advanced joining techniques at 194 for dissimilar metals, the use of titanium as the sensor face 120 coupled with stainless steel, nickel plated brass or other materials for the housing 134 provide a cost-effective yet robust solution suited for a wider range of operating conditions.

In one aspect, an industrial control sensor 110 is provided. This includes the sensor circuit 140 to detect changes in the electromagnetic field 150 that is induced from an object or material 160 passing in proximity of the electromagnetic field. The sensor 110 includes the housing 134 that employs the sensor circuit as part of an inductive proximity sensor, for example. The sensor face 120 is attached to the housing 134, where the sensor face receives the changes in the electromagnetic field 150 and transmits the changes to the sensor circuit 140, where the sensor face has a higher electrical resistivity and/or a lower temperature coefficient of resistivity than stainless steel. The sensor face 120 can be titanium, for example. This includes a titanium alloy such as an alpha alloy, a beta alloy, or an alpha-beta alloy described below.

In one example, the housing 134 is stainless steel, where the housing is bonded via at least one joint weld 194 to the sensor face 120 having a dissimilar material from the housing. In another example, the dissimilar material is a titanium alloy and the housing 134 is stainless steel. Note that the joint weld 194 can be a friction weld or a laser beam weld, for example. In yet another example, the housing 134 and the sensor face 120 are constructed from titanium or from a titanium alloy. In yet another example, the housing 134 is brass, where the sensor circuit 140 activates at least one output 170 that is communicated to an industrial control system 180 for processing.

In another aspect, an industrial control method is provided. This includes detecting disturbances in an oscillator generated electromagnetic field induced from an object or material passing in proximity of the oscillator generated electromagnetic field; employing a housing for a sensor circuit as part of a proximity sensor, the sensor circuit produces the oscillator generated electromagnetic field; and coupling a sensor face to the housing, the sensor face detects the disturbances in the oscillator generated electromagnetic field and couples the disturbances to the sensor circuit, where the sensor face has a higher electrical resistivity and/or a lower temperature coefficient of resistivity than stainless steel.

In yet another aspect, an industrial control sensor 110 is provided. This includes means for detecting changes (sensor circuit 140, sensor face 120) in an electromagnetic field 150 induced from an object or material 160 passing in proximity of the electromagnetic field. This also includes means for housing (housing 134) the sensor circuit 140 as part of a proximity sensor 110. This also includes means for joining (e.g., joints 194) the sensor face 120 to the housing 134, the sensor face receives the changes in the electromagnetic field 150 and communicates the changes to the sensor circuit 140, where the sensor face has a higher electrical resistivity and/or a lower temperature coefficient of resistivity than stainless steel as illustrated at 130. In another aspect, the housing 134 is stainless steel and the sensor face 120 is titanium or a titanium alloy that includes alpha alloys, beta alloys, or alpha-beta alloys.

It is noted that components associated with the process 100 and industrial control system 180 can include various computer or network components such as servers, clients, controllers, industrial controllers, programmable logic controllers (PLCs), energy monitors, batch controllers or servers, distributed control systems (DCS), communications modules, mobile computers, wireless components, control components and so forth that are capable of interacting across a network. Similarly, the term controller or PLC as used herein can include functionality that can be shared across multiple components, systems, or networks. For example, one or more controllers can communicate and cooperate with various network devices across the network. This can include substantially any type of control, communications module, computer, I/O device, sensors, Human Machine Interface (HMI) that communicate via the network that includes control, automation, or public networks. The controller can also communicate to and control various other devices such as Input/Output modules including Analog, Digital, Programmed/Intelligent I/O modules, other programmable controllers, communications modules, sensors, output devices, and the like.

The network can include public networks such as the Internet, Intranets, and automation networks such as Control and Information Protocol (CIP) networks including DeviceNet and ControlNet. Other networks include Ethernet, DH/DH+, Remote I/O, Fieldbus, Modbus, Profibus, wireless networks, serial protocols, and so forth. In addition, the network devices can include various possibilities (hardware or software components). These include components such as switches with virtual local area network (VLAN) capability, LANs, WANs, proxies, gateways, routers, firewalls, virtual private network (VPN) devices, servers, clients, computers, configuration tools, monitoring tools, or other devices.

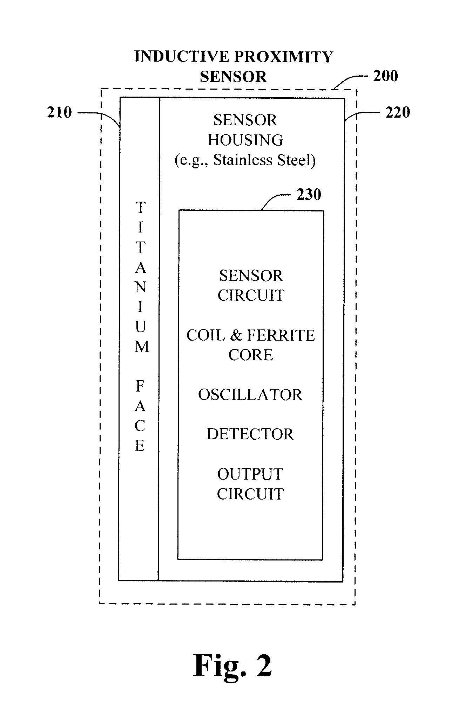

Turning now to **Fig. 2****,** a detailed sensor diagram is illustrated. An inductive proximity sensor 200 (also referred to as the sensor) includes a titanium face 210 (or titanium alloy). The sensor 200 includes a housing 220 having a sensor circuit 230 that generates an electromagnetic field through the titanium face 210. In general, inductive proximity sensors 200 operate by generating an electromagnetic field and detecting the eddy current losses generated when ferrous and nonferrous metal target objects enter the field. The sensor circuit 230 includes a coil on a ferrite core, an oscillator, a trigger-signal level detector, and an output circuit. As a metal object advances into the field, eddy currents are induced in the target. The result is a loss of energy and smaller amplitude of oscillation. The sensor circuit 230 then recognizes a specific change in amplitude and generates a signal which will turn a solid-state or relay output "ON" or "OFF" and AC or DC. As noted previously, the output can include transistors (e.g., NPN, PNP), thyristors, or relay contacts, for example.

The following describes some example applications for inductive sensors 200. In one aspect, lead frame position detection can be supported. Inductive proximity sensors are used to detect to the position of integrated circuit lead frames. The proximity sensor in this case detects the position of the alignment hole. In electronic packaging, space is an important issue. This makes the separate amplifier proximity sensor a useful solution. In another example, Injection mold closure detection can be provided. Plastic injection machines can generate a lot of heat due to energy dissipations from molten materials. Therefore, in this application, the inductive proximity sensor should be resistant to high temperatures. Again, a separate sensing head can be used. The sensor is used to detect when the injection mold tool is closed, for example.

In another application example, lathe control can be provided. When the cutting tool is at a first position and the start button is depressed, the tool post motor operates and the cutting tool moves quickly. When the cutting tool reaches a second position, the speed of the motor reduces, causing the cutting tool to move slowly. In another aspect, float detection for flow control is provided. The needed flow value can be maintained through inductive proximity sensing external detection methods using a tapered pipe and a float covered in aluminum foil, for example. As noted previously, other applications can include material tracking controls such as employed by delivery vehicles that operate over a wide range of temperatures.

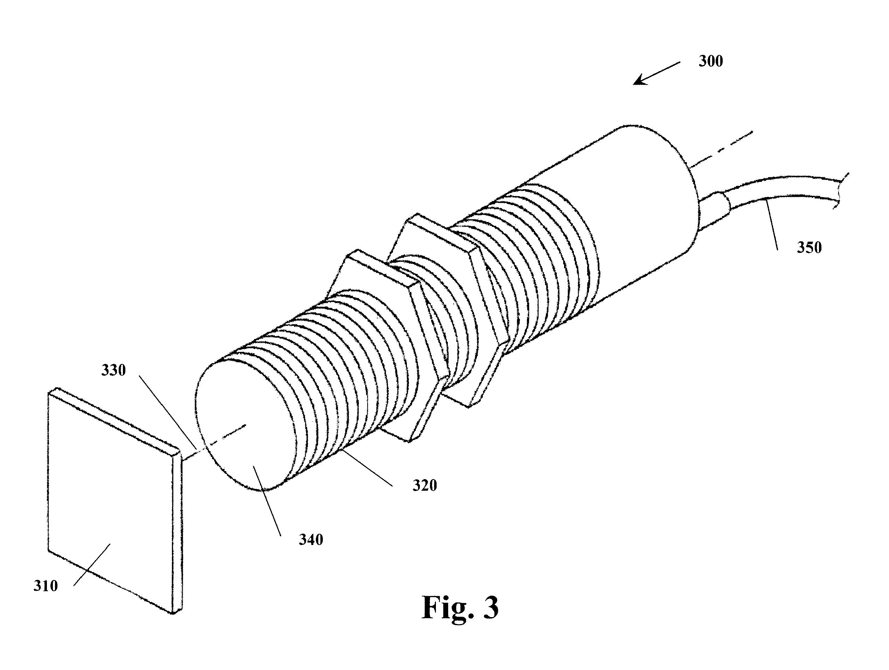

**Fig. 3** illustrates an example of an industrial control, such as an inductive proximity sensor 300 for sensing one or more target objects 310. The proximity sensor 300 has an elongate cylindrical housing 320. The housing 320 can have a variety of shapes depending upon application needs. For instance, the housing 320 can have a rectangular prism shape, cube shape, or other shapes. The housing 320 is partly defined by a longitudinal axis 330. A sensing face 340 is located at one end of the housing 320 to permit the associated circuitry that is located within the housing 320 to perform a proximity sensing function through the sensing face 340. The thickness of the sensing face 340 can vary depending upon application needs. The sensing face 340 may be formed as an integral part of the housing 320 or may be a separate component which is then attached to the housing 320 by a variety of joining techniques. In accordance with one aspect, the sensing face 340 can be constructed from a material with a higher electrical resistivity and/or lower temperature coefficient of resistivity than stainless steel, such as a titanium alloy with an alpha, alpha-beta, or beta microstructure, in order to provide enhanced sensor performance. A connection means 350, such as a cable or other connection means known in the art is located opposite the sensing face 340.

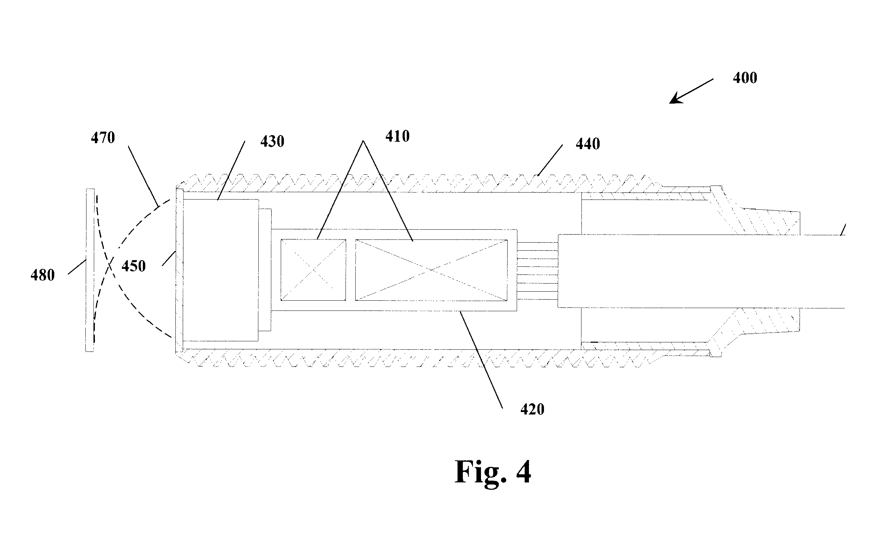

Referring to **Fig. 4****,** the inductive proximity sensor 400 includes internal electronics, such as sensing circuitry 410, such as that for an inductive type of proximity sensor. A printed circuit board 420, with components of the sensing circuitry 410 mounted thereon, is coupled to a coil assembly 430 which is disposed within a housing 440 at a location adjacent to a sensing face 450. The coil assembly 430 includes a coil on a ferrite core while the sensing circuitry 410 includes an oscillator, trigger-signal level detector, and an output circuit. A connection means 460 is located opposite the sensing face 450 for providing power and communicating an output signal. The sensing circuitry 410 generates an electromagnetic field 470 through the sensor face 450. As a metallic target object 480 enters the electromagnetic field 470, eddy currents are induced in the sensor face 450 and target object 480. The result is a loss of energy and a change in amplitude of oscillation. The sensing circuitry 410 then recognizes a specific change in amplitude and generates a signal that changes the output state "ON" or "OFF."

In one particular aspect, the sensor face 450 and housing 440 are constructed from the same materials, such as titanium alloy. In this case, the sensor face 450 and housing 440 may be fabricated as a single component or they may be fabricated as separate components which are then joined together through the use of various joining techniques. Another aspect consists of the sensor face 450 and the housing 440 being constructed from dissimilar materials, such as a sensor face 450 made of titanium alloy joined to the housing 440 made of stainless steel, nickel plated brass, anodized aluminum, or a different titanium material, for example. Thus, specialized joining techniques (described in more detail below) are provided to attach the sensor face 450 and housing 440.

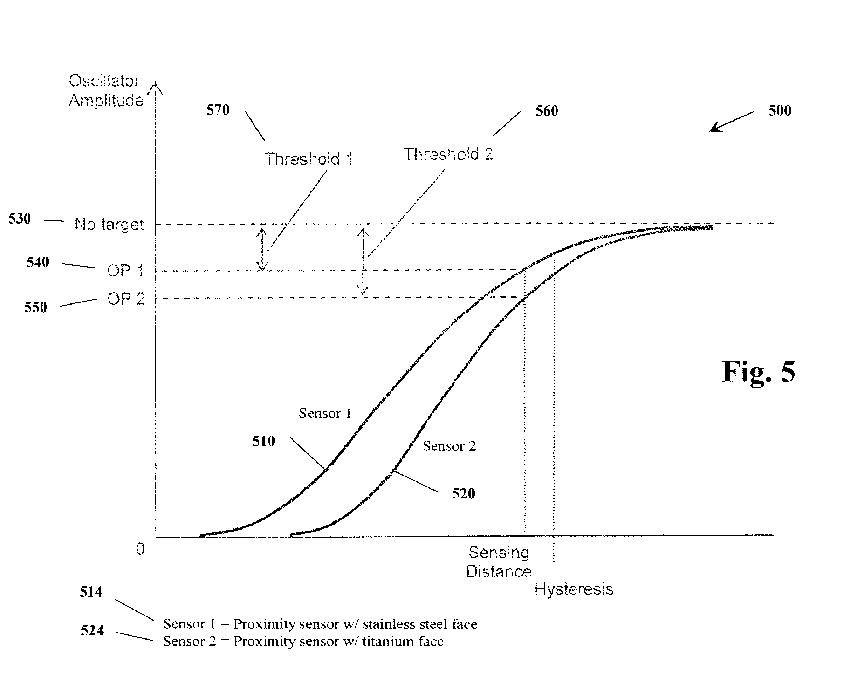

**Fig. 5** illustrates typical performance curves 500 depicting how inductive proximity sensor oscillators change. An oscillation amplitude vs. distance performance curve 510 is shown for a conventional inductive proximity sensor with a stainless steel sensor face 514 (Sensor 1). An oscillation amplitude vs. distance performance curve 520 is shown for an enhanced inductive proximity sensor with a titanium alloy sensor face 524 (Sensor 2). The proximity sensor with the titanium face 524 is more sensitive to the presence of a target than the proximity sensor with the stainless steel face 514. For example, consider the proximity sensor with the stainless steel face 514. If there is no target in proximity of the sensor 514, the oscillation amplitude is balanced at a 'No Target' level 530. When a target moves into the sensing area, the oscillation amplitude begins to drop due to the eddy current loss in the target. When the distance between the sensor 514 and target is less than the sensing distance, the oscillation amplitude is lower than the operating point 540 (OP 1) and the triggering signal will be sent. For the same sensing distance, the proximity sensor with the titanium face 524 has a lower oscillation amplitude and lower operating point 550 (OP 2). The proximity sensor with the titanium face 524 has a threshold 560 (Threshold 2) which is greater than a threshold 570 (Threshold 1) of the sensor with the stainless steel face 514. In general, higher thresholds are desired in order to counter environmental disturbances such as temperature changes and electromagnetic noise, for example.

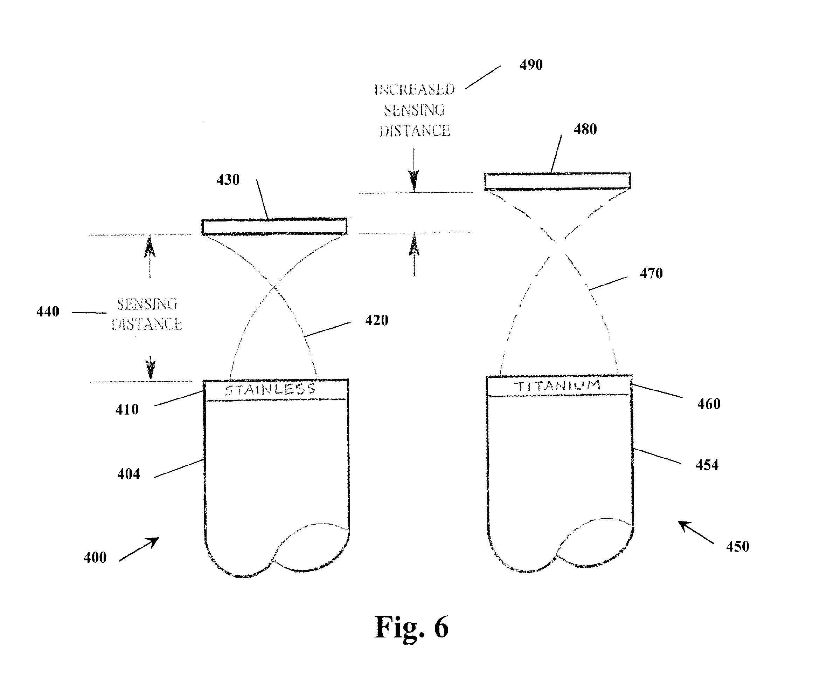

Referring to **Fig. 6****,** the performance characteristics of example proximity sensors with different sensor face materials are illustrated. A conventional inductive proximity sensor 400 consists of a stainless steel housing 404 and a stainless steel sensor face 410 located at one end of the housing 404. An electromagnetic field 420 penetrates the stainless steel sensor face 410 and extends outward towards a metallic target object 430. The distance at which the target object 430 is detected by the proximity sensor 400 is the sensing distance 440.

An enhanced inductive proximity sensor 450 is shown adjacent to the conventional inductive proximity sensor 400 to illustrate performance differences. The enhanced inductive proximity sensor 450 consists of a housing 454 made of titanium, stainless steel, nickel plated brass, anodized aluminum, or other materials. A sensor face 460 made of titanium alloy, and having a higher electrical resistivity and/or lower temperature coefficient of resistivity than stainless steel, is located at one end of the housing 454. An electromagnetic field 470 penetrates the sensor face 460 and extends outward towards a metallic target object 480. As a result of the sensing face 460 being made of a titanium alloy having a higher electrical resistivity and/or lower temperature coefficient of resistivity than stainless steel, increased sensing distances 490 can be achieved.

Electrical resistivity is a measure of a material's opposition to the flow of electrical current through it. The amount of opposition varies with the type of material. According to electromagnetic theory, when conductors, such as a metal sensor face, are exposed to an electromagnetic field, such as that generated by a proximity sensor, a circulating flow of electrons, or eddy currents, are induced in the proximity sensor face. These eddy currents induce a magnetic field that opposes the electromagnetic field generated by the proximity sensor and prevents it from penetrating the sensor face. Materials with low electrical resistivity are good conductors and readily allow the movement of an electric current. Therefore, using a material with a low electrical resistivity, such as copper (1.7-3.8 microhm-cm) or aluminum (2.8-5.9 microhm-cm), for example, will produce strong eddy currents in the sensor face that prevent the electromagnetic field generated by the proximity sensor from adequately penetrating the material. The result is a proximity sensor with a greatly reduced or no sensing distance. A material with a high electrical resistivity is thus preferred in order to reduce the intensity of these eddy currents on the sensing face and allow sufficient penetration of the electromagnetic field through the sensor face.

Titanium and, more particularly, titanium alloys are well suited for use in inductive proximity sensors due to their higher electrical resistivity than stainless steels. However, not all forms of titanium are suitable for the intended proximity sensor application. Some titanium materials, such as the unalloyed ASTM Grades I through 4 (45-60 microhm-cm) and the light alloy ASTM Grades 7, 11 & 12 (52-55 microhm-cm), for example, have electrical resistivity values that are lower than that of stainless steel and thus are not suitable candidates for use as a proximity sensor face. Likewise, not all titanium alloys are suitable for use as a proximity sensor face as well. In general, titanium alloys with an electrical resistivity of approximately 170 microhm-cm or greater, such as, but not limited to, ASTM Grade 5 titanium alloy (Ti-6A1-4V) (177 microhm-cm) are particularly well suited for use as a proximity sensor face. By comparison, sensor faces made of stainless steel are typically made of UNS S30300/UNS S30400 stainless steel (72 microhm-cm) or UNS S316000/UNS 31603 stainless steel (74 microhm-cm). Therefore, it can be seen that titanium and, more particularly, titanium alloys have an electrical resistivity that is advantageously more than twice that of typical stainless steels used for sensing faces. The high electrical resistivity of titanium alloys provides a significant advance for inductive proximity sensor applications. Thus, a sensor face made from such a material can increase the achievable sensing distance. For example, under the same test conditions, sensors made with an ASTM Grade 5 titanium alloy sensor face were observed to exhibit a 20% (24mm vs. 20mm) increase in sensing distance over sensors made with a stainless steel sensor face.

Titanium alloys with a lower temperature coefficient of resistivity than stainless steel also offer advantages when exposed to temperature changes. The electrical resistivity of a material varies as a function of temperature. The electrical resistivity of a material generally increases with increasing temperature and decreases with decreasing temperature. For example, a typical UNS S30400 stainless steel sensor face has a temperature coefficient of resistivity of approximately 0.001/°C while that of ASTM Grade 5 titanium alloy (Ti-6A1-4V) is approximately 0.00046/°C. Thus, when exposed to the same temperature range, the electrical resistivity of a sensor face made of ASTM Grade 5 titanium alloy (Ti-6A1-4V) will vary less over temperature than that of a sensor face made of UNS S30400 stainless steel.

For example, it was observed that under the same test conditions and with the same electrical circuits, a sensor with a face made of titanium alloy had a temperature sensitivity (voltage change over temperature) of 0.011 Volt/°C, while a sensor with a face made of stainless steel had a temperature sensitivity of 0.043 Volt/°C. For the same threshold, if not considering temperature compensation circuitry, environmental temperature changes could drive the sensor with a stainless steel sensor face over the threshold more easily and cause false detection. Additionally, because the titanium alloy sensor face has a high electrical resistivity and the sensor is more sensitive to the target, if the same sensing distance is assumed, then the titanium alloy sensor face could have a higher threshold (0.160 Volt, for example) than that of stainless steel (0.100 Volt, for example. Therefore, the use of titanium alloys with a lower temperature coefficient of resistivity than stainless steel can also reduce the sensor's sensitivity to temperature changes in the environment.

Another benefit associated with the use of a titanium alloys with a higher electrical resistivity and/or lower temperature coefficient of resistivity than stainless steel as a sensor face is that for the same sensing distance, a sensor face made of titanium alloy can have a greater thickness than a sensor face made of stainless steel. For example, it was observed that for the same sensing performance and with the same electrical circuits, the thickness of a sensor face made from titanium alloy (0.036") was twice that of a sensor face made from stainless steel (0.018"). A thicker sensing face offers improved durability, impact resistance, and robustness to a proximity sensor product. In addition to the above mentioned benefits, titanium, in general, also has a unique set of properties that make it a desirable material for use in proximity sensor faces. These include suitable impact properties at low temperature and excellent corrosion resistance that often exceeds that of stainless steels in most environments. These properties address a market need for proximity sensors designed with rugged packaging to meet the demands of the harsh environments these sensors are utilized in.

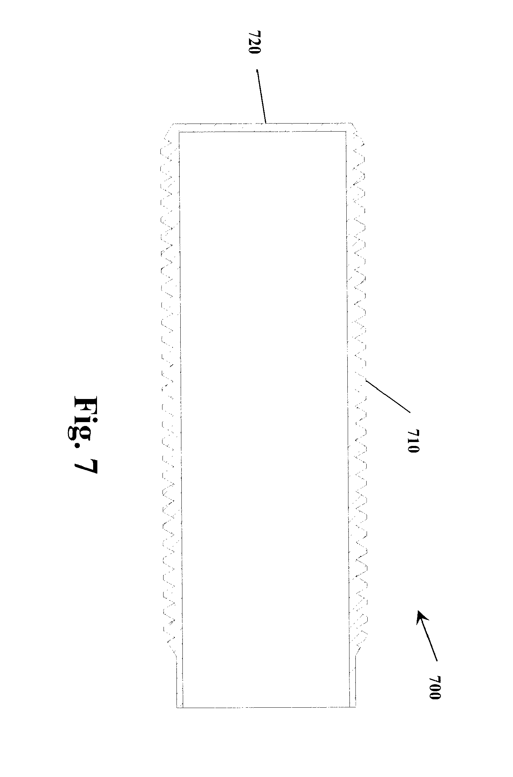

**Fig. 7** illustrates an example sensor housing construction 700. A housing 710 has a sensing face 720 located at one end that is formed as an integral part of the housing 710. The housing 710 and sensing face 720, being formed as a singular component, are therefore constructed of the same material. This being the case, the proper selection of titanium, and more particularly a titanium alloy with a higher electrical resistivity and/or lower temperature coefficient of resistivity than stainless steel, is of particular utility. The sensor housing construction 700 may be fabricated by various means, such as by machining or metal injection molding, for example. In the case of metal injection molding, there are a limited number of suitable titanium alloys available for use in the fabrication of a sensor housing/face, the most notable of which is Grade 5 titanium alloy (Ti-6A1-4V), for example.

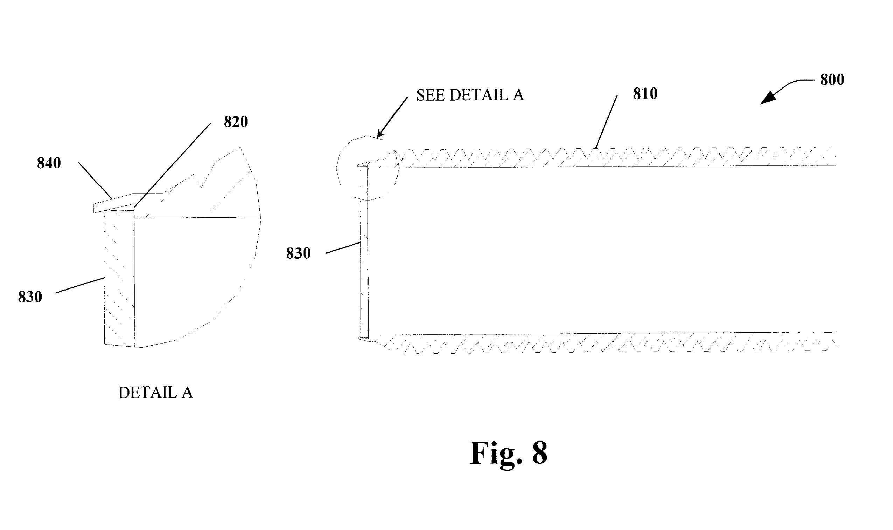

**Fig. 8** illustrates another example of a sensor housing construction 800. A housing 810 has a shelf 820 located in the interior of the housing at one end. A sensor face 830 constructed of titanium, and more particularly a titanium alloy with a higher electrical resistivity and/or lower temperature coefficient of resistivity than stainless steel, sits on the shelf 820. A portion of the housing at 840, which extends slightly beyond the outer surface of the sensor face 830, is mechanically bent inwards through a process of swaging, crimping, or forming to join the sensor face 830 to the housing 810. The housing 810 can be constructed of titanium (or alloy thereof), stainless steel, nickel plated brass, anodized aluminum, or other material, for example.

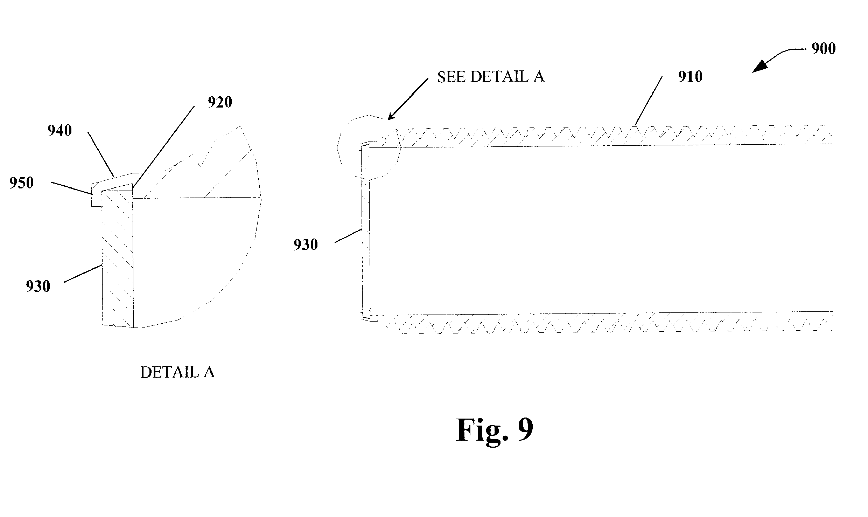

**Fig. 9** illustrates another example of a sensor housing construction 900. A housing 910 has a shelf 920 located in the interior of the housing at one end. A sensor face 930 constructed of titanium, and more particularly a titanium alloy with a higher electrical resistivity and/or lower temperature coefficient of resistivity than stainless steel, sits on the shelf 920. A portion of the housing at 940, which extends slightly beyond the outer surface of the sensor face 930, is mechanically bent inwards through a process of swaging, crimping, or forming to join the sensor face 930 to the housing 910. A portion of the housing at 950 is further bent over the outer edge of the sensor face 930 until it comes in contact with the outer surface of the sensor face 930 to provide additional strength to the attachment between the housing 910 and sensor face 930 and to conceal the otherwise exposed edges of the sensor face 930. The housing 910 can be constructed of titanium (or alloy thereof), stainless steel, nickel plated brass, anodized aluminum, or other material, for example.

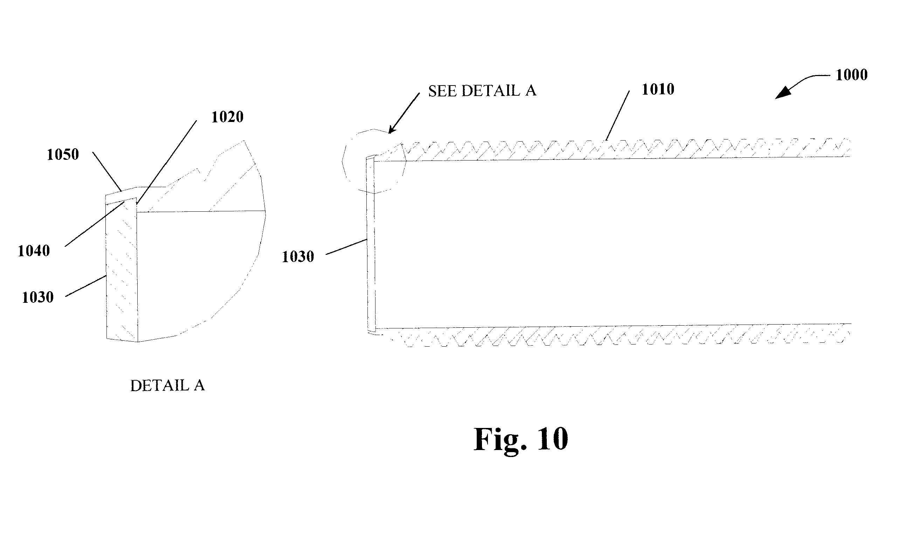

**Fig. 10** illustrates another example of a sensor housing construction 1000. A housing 1010 has a shelf 1020 located in the interior of the housing at one end. A sensor face 1030 constructed of titanium, and more particularly a titanium alloy with a higher electrical resistivity and/or lower temperature coefficient of resistivity than stainless steel, sits on the shelf 1020. The sensor face 1030 has beveled sides at 1040. A portion of the housing at 1050 is mechanically bent inwards through a process of swaging, crimping, or forming until the inner surface of housing portion 1050 makes contact with the beveled sides 1040 of the sensor face 1030, to join the sensor face 1030 to the housing 1010. As a result, the beveled sides 1040 of the sensor face 1030 provide additional strength to the attachment between the housing 1010 and sensor face 1030. The housing 1010 can be constructed of titanium (or alloy thereof), stainless steel, nickel plated brass, anodized aluminum, or other material, for example.

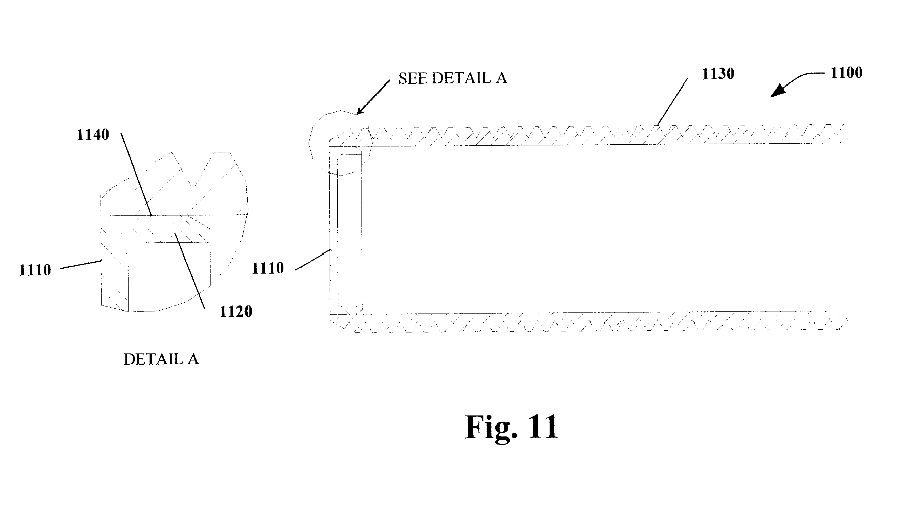

**Fig. 11** illustrates another example of a sensor housing construction 1100. A sensor face 1110 constructed of titanium, and more particularly a titanium alloy with a higher electrical resistivity and/or lower temperature coefficient of resistivity than stainless steel, has side walls 1120 that fit inside a housing 1130. The housing 1130 and sensor face 1110 are joined together at an interference press fit 1140. The housing 1130 can be made of titanium (or alloy thereof), stainless steel, nickel plated brass, or anodized aluminum, for example. The sensor face 1110 can be fabricated via a variety of processes including machining, deep drawing, or metal injection molding.

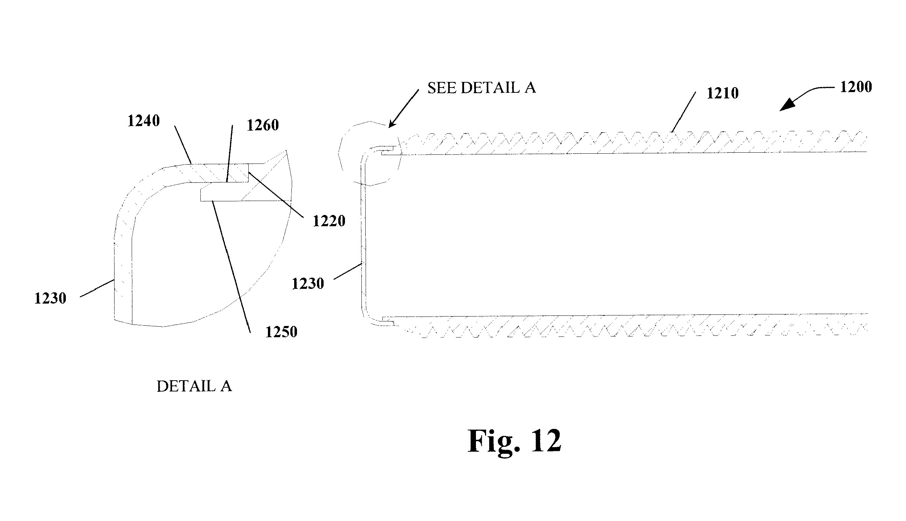

**Fig. 12** illustrates another example of a sensor housing construction 1200. A housing 1210 has a shelf 1220 located on the exterior of the housing at one end. A sensor face 130 constructed of titanium, and more particularly a titanium alloy with a higher electrical resistivity and/or lower temperature coefficient of resistivity than stainless steel, sits on the shelf 1220. The sensor face 1230 has side walls 1240 that fit over an extended portion of the housing at 1250 that serves to position the sensing face 1230 on the housing 1210. The housing 1210 and sensor face 1230 are joined together at an interference press fit 1260. The housing 1210 can be constructed of titanium (or alloy thereof), stainless steel, nickel plated brass, or anodized aluminum, for example. The sensor face 1230 can be fabricated via a variety of processes including machining, deep drawing, or metal injection molding.

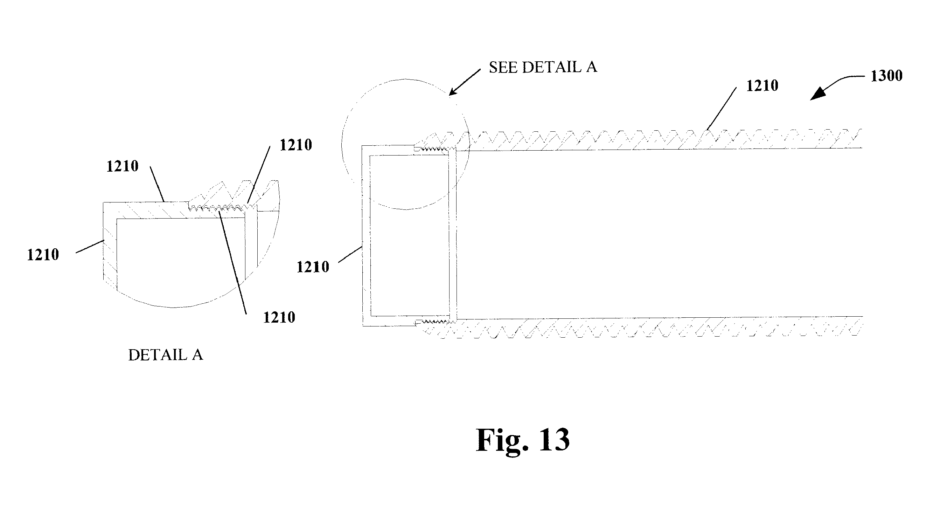

**Fig. 13** illustrates another example of a sensor housing construction 1300. A housing 1310 has internal threads 1320 located at one end of the housing. A sensor face 1330 constructed of titanium, and more particularly a titanium alloy with a higher electrical resistivity and/or lower temperature coefficient of resistivity than stainless steel, has side walls 1340 with external threads 1350. The housing 1310 and sensor face 1330 are joined together by threading the sensor face 1330 to the housing 1310 via complementary threads 1320, 1350. The housing 1310 can be constructed of titanium (or alloy thereof), stainless steel, nickel plated brass, or anodized aluminum, for example. The sensor face 1330 can be fabricated via a variety of processes including machining or metal injection molding.

While different techniques for joining the sensor face to the housing have been discussed here, it should be understood and appreciated that the above mentioned techniques are not intended to be restrictive or all inclusive. Other techniques for joining both similar and dissimilar metal combinations will be apparent to those skilled in the art, such as adhesive bonding, welding (in a variety of techniques), and brazing, for example.

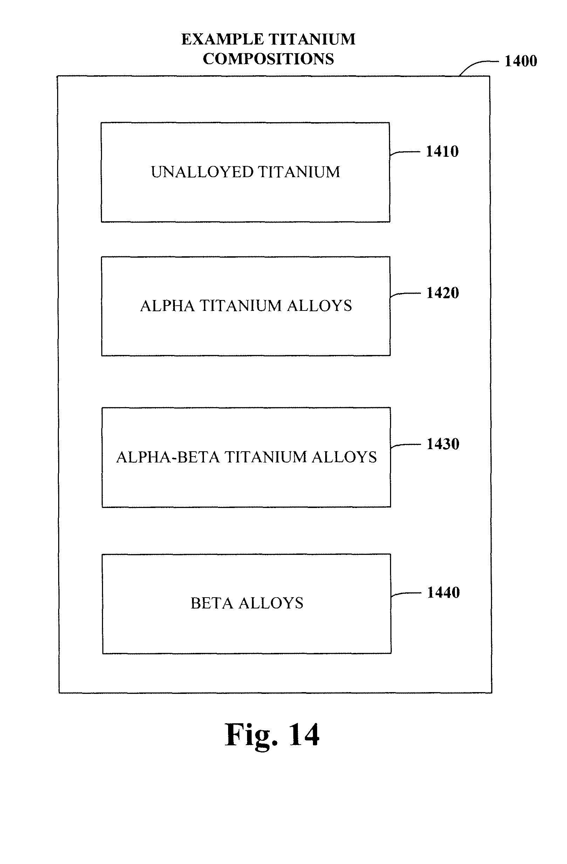

**Fig. 14** illustrates some example titanium compositions 1400 that can be employed with an enhanced proximity sensor. The utilization of titanium for the proximity sensor face makes careful titanium material selection an important factor in creating a successful dissimilar metal joint. Titanium comes in a variety of forms. Not all forms of titanium are structurally, metallurgically, or economically suitable for the intended proximity sensor application. A suitable understanding of titanium is considered before a commercially available titanium grade can be selected.

Titanium is the ninth most abundant element in the earth; occurring only as rutile ore (TiO2) or as ilmenite ore (FeTiO3). Titanium has a unique set of properties that make it a desirable material. Titanium is a lightweight, non-magnetic, material whose density is approximately 60% of that of steel and approximately 50% of that of nickel and copper alloys. Titanium has an excellent strength-to-weight ratio and has a modulus of elasticity that is approximately 55% of that of steel. Titanium has good impact properties at low temperatures. Titanium also has excellent corrosion resistance in highly oxidizing to mildly reducing environments, including chlorides that exceed that of most stainless steels. Although titanium has a higher cost than stainless steel or brass, in the long run, titanium is often more economical because it has a service life of 20-40 years and is virtually maintenance free.

Titanium is an allotropic element that exists in two crystallographic forms. The first occurs in unalloyed (commercially pure) titanium at room temperature. This form is known as the alpha (α) phase. The alpha phase has a hexagonal close-packed (hcp) crystal structure. The second form occurs at approximately 1621°F (883°C) when the hexagonal close-packed crystal structure transforms into a body-centered cubic (bcc) crystal structure known as the beta (β) phase. The transformation temperature (beta transus) is strongly affected by the addition of other elements. The addition of the alpha stabilizers oxygen, nitrogen, and carbon can raise the transformation temperature. The addition of the beta stabilizer hydrogen can lower the transformation temperature. The addition of alloying elements or the presence of metallic impurities can raise or lower the beta transus. Titanium can be classified into three categories based upon their crystal structure: alpha alloys, alpha-beta alloys, and beta alloys.

At 1410 of **Fig. 14****,** unalloyed titanium is considered. All unalloyed (commercially pure) grades of titanium have an alpha microstructure. The material properties of commercially pure (98%-99.5% Ti) titanium are affected by the addition of oxygen, nitrogen, carbon, and iron in small quantities. Grades of high purity titanium have a lower strength, hardness, and transformation temperature than grades of lower purity. Unalloyed titanium is susceptible to both oxidation and solid-solution hardening when heated in air. The oxygen and nitrogen in the air is highly soluble with titanium and can diffuse into the heated metal, causing a reduction in fatigue strength and ductility. Unalloyed titanium exhibits excellent corrosion resistance and weldability properties however.

At 1420, alpha alloys are considered. Alpha alloys are predominantly single-phase alloys that contain elements of aluminum, tin, and/or zirconium. These alpha stabilizing elements, along with small amounts of oxygen, nitrogen, and carbon, have the effect of either stabilizing or increasing the transformation temperature. Alpha alloys contain large amounts of aluminum (up to 8% Al) to improve oxidation resistance at elevated temperatures. Alpha alloys, in general, have superior creep resistance than alpha-beta or beta alloys, a characteristic that makes them well suited to high temperature applications. Likewise, alpha alloys lack a ductile-to-brittle transition, a characteristic of beta alloys, which also makes them well suited to extremely low temperature applications. Alpha alloys exhibit excellent corrosion resistance and weldability.

At 1430, alpha-beta alloys are considered. Alpha-beta alloys have a two-phase microstructure that contains elements of aluminum, vanadium, chromium, and molybdenum. Large amounts of aluminum (up to 7% Al) serve to stabilize the alpha phase while varying amounts of vanadium, chromium, and molybdenum serve to stabilize the beta phase. Alpha-beta alloys contain from 10%-50% beta phase depending upon the quantity of beta stabilizers present and the heat treatment of the metal. Alpha-beta alloys have an excellent combination of strength and ductility. Alpha-beta alloys that are predominantly of the alpha phase are easily weldable while those that have a large amount of the beta phase, such as those that contain chromium, are not as easily welded.

At 1440, beta alloys are considered. Beta alloys contain a larger quantity of beta stabilizing elements and a smaller quantity of alpha stabilizing elements than alpha-beta alloys. Beta alloys are metastable in nature because cold work at ambient temperature or heating to a slightly elevated temperature can cause a partial transformation to the alpha phase. Beta alloys contain beta stabilizing elements such as vanadium, niobium, and molybdenum to reduce the transformation temperature. Beta alloys have excellent strength and hardenability. The strength of beta alloys comes from the intrinsic strength of the body-centered cubic microstructure and the precipitation of the alpha phase from the alloy through heat treatment. Beta alloys have a higher density, lower creep resistance, and less ductility than alpha-beta alloys. Beta alloys are generally not as easily welded.

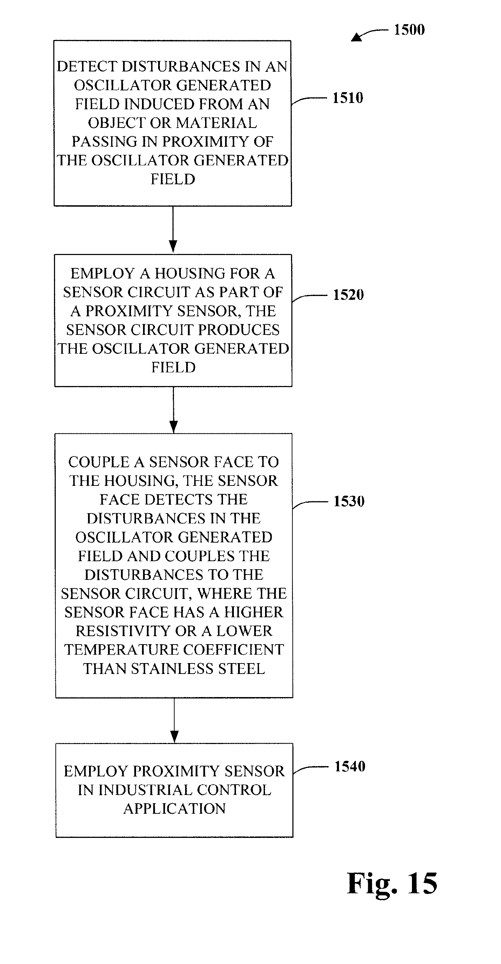

**Fig. 15** is a flow diagram illustrating an example process 1500 for an enhanced inductive proximity sensor. While, for purposes of simplicity of explanation, the methodology is shown and described as a series of acts, it is to be understood and appreciated that the methodologies are not limited by the order of acts, as some acts may occur in different orders or concurrently with other acts from that shown and described herein. For example, those skilled in the art will understand and appreciate that a methodology could alternatively be represented as a series of interrelated states or events, such as in a state diagram. Moreover, not all illustrated acts may be required to implement a methodology as described herein.

Proceeding to 1510, detect disturbances in an oscillator generated field induced from an object or material passing in proximity of the oscillator generated field. At 1520, employ a housing for a sensor circuit as part of a proximity sensor, where the sensor circuit produces the oscillator generated field. At 1530, couple a sensor face to the housing, the sensor face detects the disturbances in the oscillator generated field and couples the disturbances to the sensor circuit, where the sensor face has a higher electrical resistivity or a lower temperature coefficient of resistivity than stainless steel. At 1540, employ the proximity sensor in an industrial control application.

It is noted that as used in this application, terms such as "component," "module," "system," and the like are intended to refer to a computer-related, electro-mechanical entity or both, either hardware, a combination of hardware and software, software, or software in execution as applied to an automation system for industrial control. For example, a component may be, but is not limited to being, a process running on a processor, a processor, an object, an executable, a thread of execution, a program and a computer. By way of illustration, both an application running on a server and the server can be components. One or more components may reside within a process or thread of execution and a component may be localized on one computer or distributed between two or more computers, industrial controllers, or modules communicating therewith.

The subject matter as described above includes various exemplary aspects. However, it should be appreciated that it is not possible to describe every conceivable component or methodology for purposes of describing these aspects. One of ordinary skill in the art may recognize that further combinations or permutations may be possible. Various methodologies or architectures may be employed to implement the subject invention, modifications, variations, or equivalents thereof. Accordingly, all such implementations of the aspects described herein are intended to embrace the scope and spirit of subject claims. Furthermore, to the extent that the term "includes" is used in either the detailed description or the claims, such term is intended to be inclusive in a manner similar to the term "comprising" as "comprising" is interpreted when employed as a transitional word in a claim.

## Claims

1. An industrial control sensor, comprising:
a sensor circuit to detect changes in an electromagnetic field that are induced when a metallic object or material passes in proximity of the electromagnetic field;
a housing that employs the sensor circuit as part of an inductive proximity sensor; and
a sensor face attached to the housing, where the electromagnetic field penetrates the sensor face and allows the sensor circuit to detect changes to the electromagnetic field, where the sensor face has a higher electrical resistivity or a lower temperature coefficient of resistivity than stainless steel.

2. The industrial control sensor of claim 1, the sensor face is constructed from a titanium alloy.

3. The industrial control sensor of claim 2, the titanium alloy is an alpha, alpha-beta, or beta alloy.

4. The industrial control sensor of claim 1, the housing is stainless steel, brass, aluminum, or titanium.

5. The industrial control sensor of claim 1, the sensor face is attached to the housing via a mechanical swaging, crimping, or forming process.

6. The industrial control sensor of claim 1, the sensor face is attached to the housing via an interference press fit.

7. The industrial control sensor of claim 1, the sensor face is attached to the housing via complementary threads.

8. The industrial control sensor of claim 1, the sensor face is attached to the housing via a welding or a brazing process.

9. The industrial control sensor of claim 1, the sensor face is attached to the housing via adhesive bonding.

10. The industrial control sensor of claim 1, the housing and sensor face are integrally formed as a singular unit.

11. The industrial control sensor of claim 1, the sensor circuit activates at least one output that is communicated to an industrial control system for processing.

12. An industrial control method, comprising:
detecting changes in an oscillator generated electromagnetic field that are induced when a metallic object or material passes in proximity of the oscillator generated electromagnetic field;
employing a housing for a sensor circuit as part of a proximity sensor, the sensor circuit produces the oscillator generated electromagnetic field; and
coupling a sensor face to the housing, where the oscillator generated electromagnetic field penetrates the sensor face and allows the sensor circuit to detect the changes in the oscillator generated electromagnetic field, where the sensor face has a higher electrical resistivity or a lower temperature coefficient of resistivity than stainless steel.

13. The industrial control method of claim 12, the sensor face is constructed of a titanium alloy.

14. The industrial control method of claim 13, the titanium alloy is an alpha, alpha-beta, or beta alloy.

15. The industrial control method of claim 12, the housing is stainless steel, brass, aluminum, or titanium.

16. The industrial control method of claim 12, the sensor face is attached to the housing via a mechanical swaging, crimping, or forming process.

17. The industrial control method of claim 12, the sensor face is attached to the housing via an interference press fit, via complementary threads, via a welding process, or via a brazing process.

18. The industrial control method of claim 12, the sensor face is attached to the housing via adhesive bonding.

19. An industrial control sensor, comprising:
means for detecting changes in an electromagnetic field that are induced when a metallic object or material passes in proximity of the electromagnetic field;
means for housing a sensor circuit as part of a proximity sensor; and
means for joining a sensor face to the housing, where the electromagnetic field penetrates the sensor face and allows the sensor circuit to detect changes in the electromagnetic field and communicates the changes to the sensor circuit, where the sensor face has a higher electrical resistivity or a lower temperature coefficient of resistivity than stainless steel.

20. The industrial control sensor of claim 19, the housing is constructed of stainless steel and the sensor face is constructed of an alpha, alpha-beta, or beta titanium alloy.
